# EUROPEAN PATENT APPLICATION

(11) **EP 1 837 881 A1**
(43) Date of publication of application: **26.09.2007**
(21) Application number: 06115596.6
(22) Date of filing: 16.06.2006
(51) Int. Cl.: G11C 29/00, G11C 29/42

(54) **Redundancy-function-equipped semiconductor memory device from ECC memory**

(30) Priority: 24.03.2006 JP 2006083335
(71) Applicant: Fujitsu Ltd., Kawasaki-shi, Kanagawa 211-8588 (JP)
(72) Inventor: Eto, Satoshi FUJITSU LIMITED, Kawasaki-shi Kanagawa 211-8588 (JP)
(74) Representative: Seeger, Wolfgang

(57) **Abstract**

A semiconductor memory device includes a memory configured to input/output first data and second data in parallel, the first data being all or part of a predetermined number of bits, and the second data being comprised of a number of bits necessary to correct error of the predetermined number of bits, a unit configured to supply redundancy switching information in response to an address signal supplied to the memory, and a controlling unit situated between the memory and input/output nodes, having a first path that couples a given bit of the input/output nodes to a corresponding bit of the first data of the memory and a second path that couples the given bit of the input/output nodes to a predetermined bit of the second data of the memory, and configured to select and enable one of the first path and the second path in response to the redundancy switching information.

## Description

### BACKGROUND OF THE INVENTION

### 1. Field of the Invention

The present invention generally relates to semiconductor memory devices, and particularly relates to a semiconductor memory device having a redundancy function.

### 2. Description of the Related Art

With respect to semiconductor memory devices, the methods for fixing errors include a redundancy method that utilizes backup memory cells and a data correction method that utilizes error correcting codes (ECC).

In a semiconductor memory device having the redundancy function, when a defective memory cell is in existence, such cell is replaced with a redundant memory cell serving as a backup memory cell, and an access to the address of this defective memory cell is directed to this redundant memory cell, thereby making it possible to use the address of the defective memory cell. In order to replace a defective memory cell with a redundant memory cell, the address of the defective memory cell needs to be recorded. In a typical redundancy system, fuses are provided, and the state of the fuses (cut or intact) is utilized to record defective addresses.

An ECC memory (Error Check and Correct memory) having an ECC-based data correcting function calculates redundant bits for the error correction purpose based on the data to be written, and stores in the memory core the calculated redundant bits together with the data to be written. At the time of data reading, retrieved data and redundant bits are checked to see if the data (& redundant bits) contain an error. If error is detected, error correction is performed. If the Hamming code is used for error correction, for example, error correction is possible if one-bit error occurs in the code, while only error detection is possible if two-bit error occurs.

When the Hamming code is used, 4 bits are needed as redundant bits for data of 8-bit width, 5 bits needed as redundant bits for data of 16-bit width, 6 bits needed as redundant bits for data of 32-bit width, and 7 bits needed as redundant bits for data of 64-bit width. The smaller the ratio of the number of redundant bits to the number of data bits, the greater the utilization of the memory resources. In consideration of this, even when the bit width of data for read/write operation is 32 bits with respect to an interface with the exterior, for example, the data read/write operation may be performed by use of 64-bit data width with respect to the memory core.

An ECC memory can fix a defect in a code such that the code (data + redundant bits) are self-consistent. However, the computation time for error correction is necessary, and, also, there is a penalty in terms of data access time and cycle time as will be described below in the case of the above-described configuration in which the bit width of input/output data with respect to the memory core is set wider than the bit width of input/output data with respect to an interface with the exterior.

At the time of read operation, a code (comprised of 64 data bits + 7 redundant bits) is retrieved and subjected to ECC computation for error correction. Among the 64 retrieved data bits, 32 data bits of the data portion corresponding to the read address is output to the exterior.

At the time of write operation, write data comprised of 32 bits is input from the exterior, but this write data alone is not sufficient to generate redundant bits for the error correction purpose. To obviate this problem, 32 data bits are retrieved from the memory core and merged with the write data to generate 64-bit data. This 64-bit data is used to generate 7 redundant bits, followed by writing a code (the 64 data bits plus the 7 redundant bits) to the memory core.

In this manner, a write operation with respect to the ECC memory involves a read operation performed first and a write operation performed thereafter. This gives rise to a problem in that the operation speed becomes slow, and also in that excessive power consumption is required.

In the case of an SOC (System on Chip), a memory module is embedded in a single chip together with other modules, so that it is difficult to use the redundancy function requiring fuse cutting. An ECC memory is thus used more often than not. Depending on user needs, there may be a case in which a high-speed memory operation using the redundancy function capable of high-speed operation as a defect fixing function is used in place of the ECC function, which results in the lowering of operation speed. In such a case, however, if a built-in ECC memory already embedded in the system is modified with some design change into a memory having the redundancy function, a prohibitively large number of design steps and large amount of design time would be necessary. Accordingly, there is a need to modify an ECC memory into a redundancy-function-equipped memory with a minimum design change.
[Patent Document 1] Japanese Patent Application Publication No. 10-326497
[Patent Document 2] Japanese Patent Application Publication No. 61-264599
[Patent Document 3] Japanese Patent Application Publication No. 61-50293

### SUMMARY OF THE INVENTION

It is a general object of the present invention to provide a semiconductor memory device that substantially obviates one or more problems caused by the limitations and disadvantages of the

### related art.

It is another and more specific object of the present invention to provide a redundancy-function-equipped semiconductor memory device that can be made from an ECC memory with a minimum design change.

Features and advantages of the present invention will be presented in the description which follows, and in part will become apparent from the description and the accompanying drawings, or may be learned by practice of the invention according to the teachings provided in the description. Objects as well as other features and advantages of the present invention will be realized and attained by a redundancy-function-equipped semiconductor memory device particularly pointed out in the specification in such full, clear, concise, and exact terms as to enable a person having ordinary skill in the art to practice the invention.

To achieve these and other advantages in accordance with the purpose of the invention, the invention provides a semiconductor memory device which includes a memory configured to input/output first data and second data in parallel, the first data being all or part of data comprised of a predetermined number of bits that is 2 to the power of a positive integer, and the second data being comprised of a number of bits necessary to correct error of the data comprised of the predetermined number of bits, a redundancy switching information providing unit configured to supply redundancy switching information in response to an address signal supplied to the memory, and a redundancy controlling unit situated between the memory and input/output nodes equal in number to a number of bits of the first data, having a first path that couples a given bit of the input/output nodes to a corresponding bit of the first data of the memory and a second path that couples the given bit of the input/output nodes to a predetermined bit of the second data of the memory, and configured to select and enable one of the first path and the second path in response to the redundancy switching information.

According to one embodiment of the present invention, an ECC memory is modified such that the first data (data to be written/read) and the second data (error-correction-purpose redundant bits) are input/output in parallel, with the error correction function being set to the "off" state. With this slight design modification, the memory cells corresponding to the second data can be used for the purpose of storing normal data. In such a modified ECC memory, the memory cells corresponding to the error-correction-purpose redundant bits are used as redundant cells, and the configuration to replace a defect cell with a redundant cell is added to the data input/output portion of the memory. This makes it possible to recover data through redundancy processing. Namely, a redundancy-function-equipped semiconductor memory device is provided that can be made by making minimum modification to the ECC memory.

### BRIEF DESCRIPTION OF THE DRAWINGS

Other objects and further features of the present invention will be apparent from the following detailed description when read in conjunction with the accompanying drawings, in which:
Fig. 1 is a block diagram showing the configuration of a redundancy-function-equipped semiconductor memory device according to the present invention;
Fig. 2 is a block diagram showing the configuration of a first embodiment of the ECC memory;
Fig. 3 is a drawing showing the configuration of a conventional ECC memory;
Fig. 4 is a drawing showing the configuration of a first embodiment of the redundancy controlling unit;
Fig. 5 is a drawing showing an example of the configuration of the redundancy switching information providing unit;
Fig. 6 is a drawing showing the configuration of a second embodiment of the ECC memory;
Fig. 7 is a block diagram showing the configuration of a redundancy-function-equipped semiconductor memory device when the ECC memory of the second embodiment shown in Fig. 6 is used;
Fig. 8 is a block diagram showing a variation of the configuration of a redundancy-function-equipped semiconductor memory device when the ECC memory of the second embodiment is used;
Fig. 9 is a drawing showing the configuration of a second embodiment of the redundancy controlling unit;
Fig. 10 is a block diagram showing a variation of the configuration of the redundancy-function-equipped semiconductor memory device according to the present invention;
Fig. 11 is a drawing showing the configuration of the memory shown in Fig. 10;
Fig. 12 is a block diagram showing another variation of the configuration of the redundancy-function-equipped semiconductor memory device according to the present invention;
Fig. 13 is a drawing showing an example of a nonvolatile information storage unit provided in the redundancy switching information providing unit;
Fig. 14 is a drawing showing another example of a nonvolatile information storage unit provided in the redundancy switching information providing unit;
Fig. 15 is a drawing showing another example of a nonvolatile information storage unit provided in the redundancy switching information providing unit;
Fig. 16 is a drawing showing an example of the chip configuration of the semiconductor memory device according to the present invention;
Fig. 17 is a drawing showing another example of the chip configuration of the semiconductor memory device according to the present invention; and
Fig. 18 is a drawing showing yet another example of the chip configuration of the semiconductor memory device according to the present invention.

### DESCRIPTION OF THE PREFERRED EMBODIMENTS

In the following, embodiments of the present invention will be described with reference to the accompanying drawings.

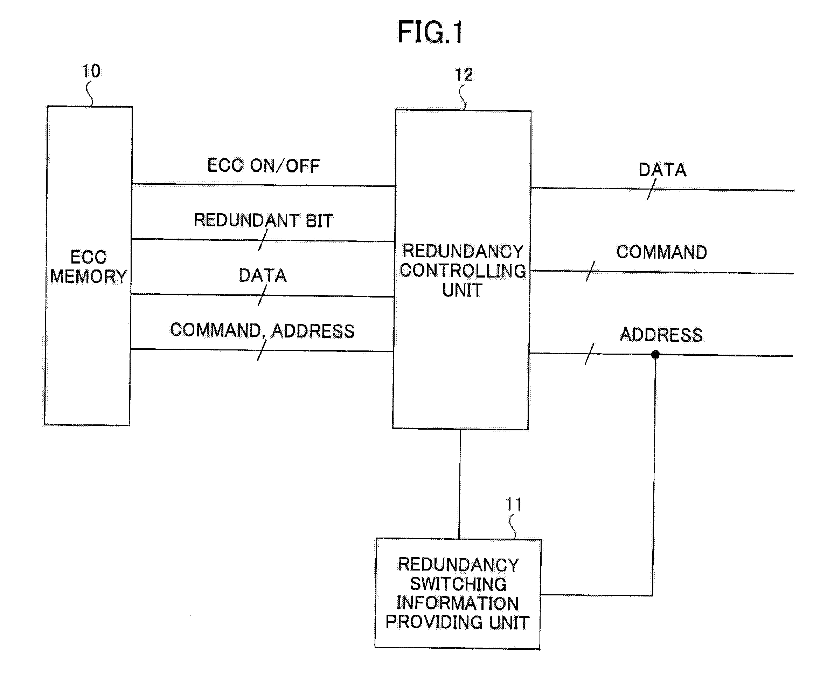

Fig. 1 is a block diagram showing the configuration of a redundancy-function-equipped semiconductor memory device according to the present invention. The redundancy-function-equipped semiconductor memory device of Fig. 1 includes an ECC memory 10, a redundancy switching information providing unit 11, and a redundancy controlling unit 12.

The ECC memory 10 is a memory block having an error correcting function utilizing the Hamming code, the extended Hamming code, the horizontal and vertical parity code, or the like. The ECC memory 10 has the terminals for inputting of a command and address, the terminals for inputting/outputting of data and redundant bits for the error correction purpose, and the terminal for inputting of an ECC-on/off signal indicating the on/off state of the ECC function.

The redundancy controlling unit 12 is provided between the ECC memory 10 and a host apparatus (e.g., CPU) reading/writing data from/to the ECC memory 10. The redundancy controlling unit 12 receives command and address signals from the host apparatus, and supplies the received command and address signals to the ECC memory 10. The command signals indicate a read command or a write command, for example. The redundancy controlling unit 12 sets the ECC-on/off signal to the off state for provision to the ECC memory 10 during the normal memory operation. Namely, the ECC function of the ECC memory 10 is suspended.

In the case of write operation, the redundancy controlling unit 12 supplies the data received from the host apparatus to the ECC memory 10. In the case of read operation, the redundancy controlling unit 12 supplies the data read from the ECC memory 10 to the host apparatus.

The ECC memory 10 includes a means to store nonvolatile information such as fuses or a ROM, which stores failed-address information and data-position information associated with the failed-address information. The failed-address information indicates the addresses of defective memory cells that are detected by the testing of the ECC memory 10 performed in advance. The data-position information indicates the position of failed bits in the data that is input/output with respect to the ECC memory 10. Namely, with the input/output data being n-bit data D1, D2, D3, ..., and Dn, the data-position information indicates "x" if the failed bit is Dx.

The redundancy switching information providing unit 11 receives the address signals that are supplied to the redundancy controlling unit 12 from the host apparatus. The redundancy switching information providing unit 11 compares the address indicated by the received address signals with addresses indicated by the failed-address information stored in the storage means, and supplies to the redundancy controlling unit 12 a match/no-match signal indicative of the result of the comparison that is either a match or no match. If the result of the comparison indicates an address match, the redundancy switching information providing unit 11 supplies the data-position information corresponding to the matched address together with the match/no-match signal to the redundancy controlling unit 12.

If the match/no-match signal from the redundancy switching information providing unit 11 indicates an address match, the redundancy controlling unit 12 assigns a data bit, corresponding to the failed bit position in the data exchanged with the host apparatus, to one bit of the redundant bits exchanged with the ECC memory 10. Namely, the data bit corresponding to the failed-bit position in the data exchanged with the ECC memory 10 is replaced with one bit of the redundant bits exchanged with the ECC memory 10. If provision is made to detect a plurality of failed bits, the plurality of failed bits may be replaced with a plurality of bits of the redundant bits.

Setting the ECC-on/off signal to the off state with respect to the ECC memory 10 turns off the ECC function of the ECC memory 10, so that the redundant bits are independent of the read/write data. Namely, the memory cells for storing the redundant bits for the error correction purpose can be used for the purpose of storing normal data. In the present invention, the memory cells for storing the redundant bits are utilized as redundant memory cells for recovering a failed bit (i.e., the bit of a defective memory cell) contained in normal data.

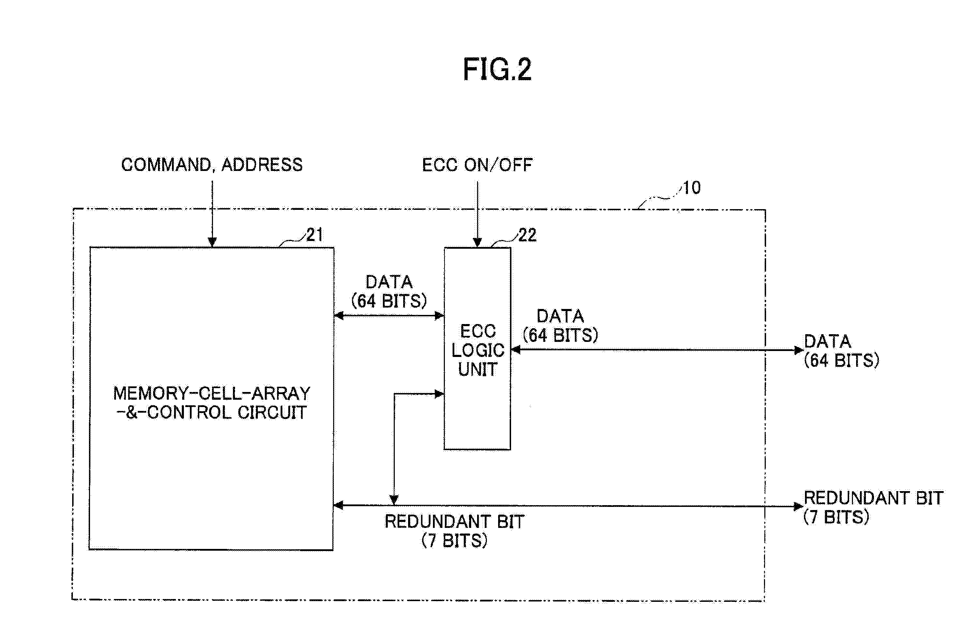

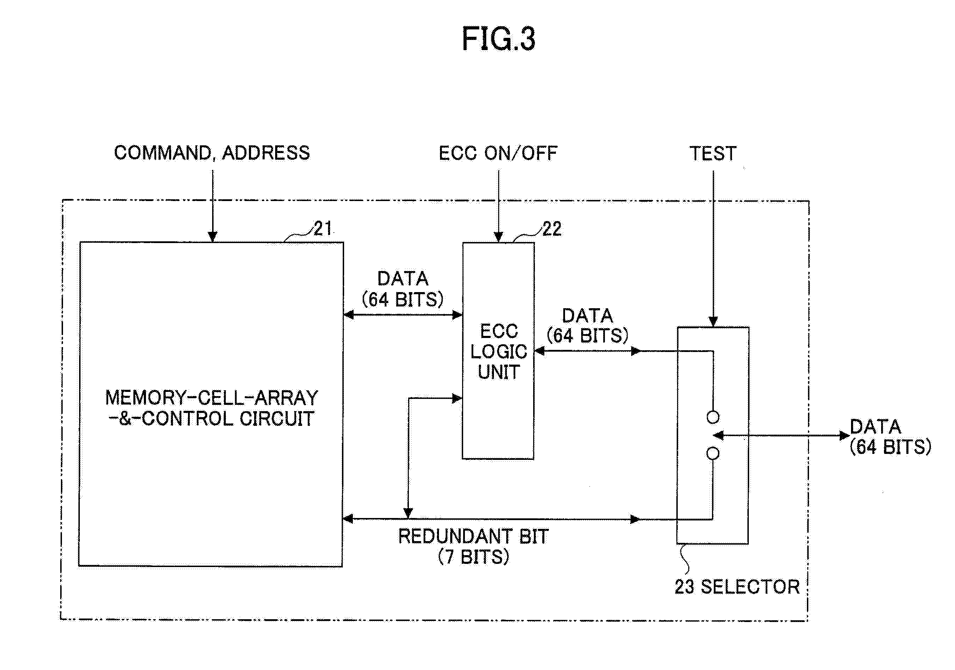

Fig. 2 is a block diagram showing the configuration of a first embodiment of the ECC memory 10. The ECC memory 10 is identical to a conventional ECC memory, except that provision is made to input/output data of the redundancy bit portion for correcting error during the normal read/write operation. Fig. 3 is a drawing showing the configuration of a conventional ECC memory illustrated for the purpose of comparison.

The ECC memory 10 of the present invention shown in Fig. 2 includes a memory-cell-array-&-control circuit 21 and an ECC logic unit 22. The conventional ECC memory shown in Fig. 3 includes the memory-cell-array-&-control circuit 21, the ECC logic unit 22, and a selector 23. The conventional ECC memory and the ECC memory 10 of the present invention share identical configurations with respect to the memory-cell-array-&-control circuit 21 and the ECC logic unit 22. In this example, input/output data is 64 bit, and the error-correction-purpose redundant bits are 7 bits.

The conventional ECC memory shown in Fig. 3 will be described first. The memory-cell-array-&-control circuit 21 includes a memory core circuit comprised of an array of memory cells and a control circuit for controlling read/write operations with respect to the memory. The memory core circuit includes a plurality of memory cells arranged in matrix form, word lines for selecting one of the rows of the memory cells, column selecting lines for selecting one of the columns, bit lines for reading data, sense amplifiers for amplifying the read data, etc. The control circuit includes a command latch, a command decoder, an address latch, a row decoder, a column decoder, a timing signal generating circuit, etc.

When a read command is input into the memory-cell-array-&-control circuit 21, 64-bit data and 7-bit redundant bits are read from the memory cells corresponding to the input address. When a write command is input into the memory-cell-array-&-control circuit 21, 64-bit data and 7-bit redundant bits are write to the memory cells corresponding to the input address.

The ECC logic unit 22 generates error-correction-purpose redundant bits and performs an error check and error correction if the ECC-on/off signal supplied from the exterior indicates the on state of the ECC function. Namely, in the case of write operation, the ECC logic unit 22 generates 7 redundant bits based on 64-bit data supplied from the exterior through the selector 23, and the 64-bit data and the 7 redundant bits are supplied to the memory-cell-array-&-control circuit 21. In the case of read operation, an error check and error correction are performed based on the 64-bit data and 7 redundant bits read from the memory-cell-array-&-control circuit 21. The 64-bit data for which error correction has been performed is output to the exterior through the selector 23.

The ECC logic unit 22 allows 64-bit data to pass through without any change if the ECC-on/off signal supplied from the exterior indicates the off state of the ECC function. Namely, the ECC logic unit 22 passes the 64-bit data received from the exterior as it is to the memory-cell-array-&-control circuit 21, and passes the data read from the memory-cell-array-&-control circuit 21 as it is to the exterior.

The selector 23 couples the 64-bit external input/output data terminals of the ECC memory to the ECC logic unit 22 at the time of normal operation. With this arrangement, 64-bit data can be read from the memory-cell-array-&-control circuit 21 and output to the exterior through the ECC logic unit 22, and 64-bit data can be written to the memory-cell-array-&-control circuit 21 from the exterior through the ECC logic unit 22.

The selector 23 is configured to assign part of the 64-bit external input/output data terminals of the ECC memory to the 7 redundant bits output from the memory-cell-array-&-control circuit 21 at the time of a test operation, in which the test signal supplied from the exterior indicates a test operation. This makes it possible that the redundant bits are observed from the exterior. With this provision, a check can be made as to whether the ECC function is properly operating at the time of testing the operation of the ECC memory.

In the ECC memory 10 of the present invention shown in Fig. 2, the selector 23 is removed. The 64-bit external input/output data terminals of the ECC memory 10 are directly connected to the ECC logic unit 22. Further, the ECC memory 10 has 7-bit redundant-bit input/output terminals in addition to the 64-bit external input/output data terminals, and the 7-bit redundant-bit input/output terminals are directly connected to the memory-cell-array-&-control circuit 21.

In this manner, the ECC memory 10 of the present invention differs from the conventional ECC memory only in that the selector 23 is removed, and in that the data paths are modified to allow 64-bit data and 7 redundant bits to be input/output from/to the exterior. With this slight design modification, the ECC memory 10 of the present invention can be created from the conventional ECC memory.

The ECC memory 10 of the present invention functions as an ECC memory in the same manner as the conventional ECC memory when the ECC-on/off signal is set to "on" to activate the ECC function. If the ECC-on/off signal is set to "off" to deactivate the ECC function, the memory cells corresponding to the 7 redundant bits can be used for the purpose of storing normal data. By utilizing this configuration, the present invention uses the memory cells corresponding to 7 error-correction-purpose redundant bits as redundant memory cells.

It should be noted that the memory-cell-array-&-control circuit 21 and the ECC logic unit 22 may be provided in a single macro, or may be separate macros on a single chip. The memory-cell-array-&-control circuit 21 and the ECC logic unit 22 may be implemented on a single silicon substrate, or may be implemented on separate silicon substrates.

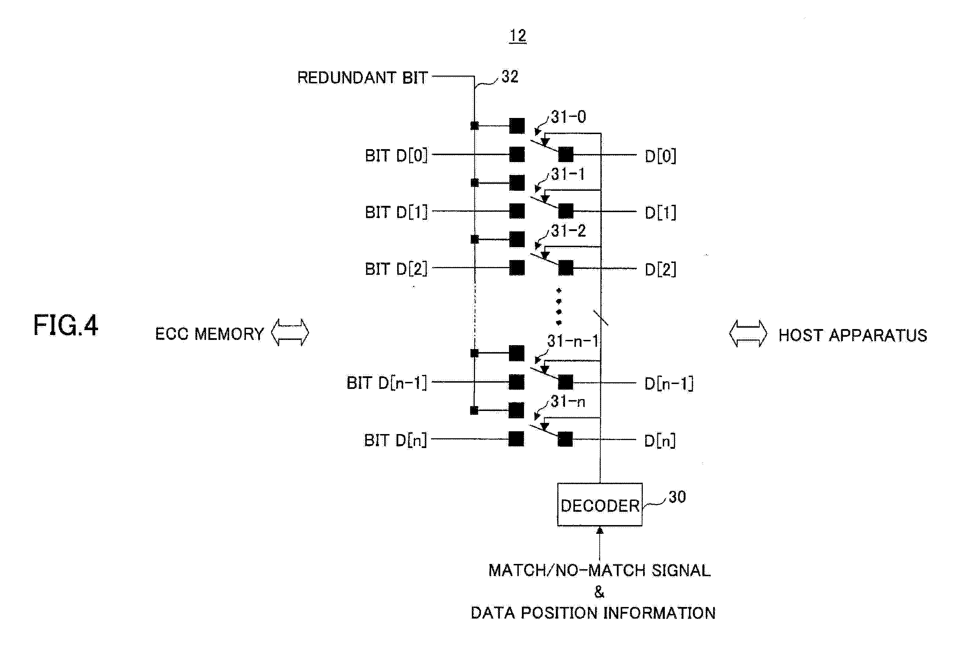

Fig. 4 is a drawing showing the configuration of a first embodiment of the redundancy controlling unit 12. The redundancy controlling unit 12 includes a decoder 30 and switches 31-0 through 31-n.

The decoder 30 receives the match/no-match signal and data-position information from the redundancy switching information providing unit 11. The switches 31-0 through 31-n are provided in one-to-one correspondence to (n+1)-bit data D[0] through D[n] that are exchanged between the host apparatus (CPU) and the ECC memory 10. The switches 31-0 through 31-n are controlled as to their switch positions according to signals from the decoder 30.

When any given switch 31-x (x: any given number between 0 and n) is set in a normal switch position, the signal line of the data D[x] on the host apparatus side is connected to the signal line of the data D[x] on the ECC memory side. When any given switch 31-x is set in a redundancy switch position, the signal line of the data D[x] on the host apparatus side is connected to a signal line 32 of a redundant bit. The redundant-bit signal line 32 is coupled to one of the redundant bits of the ECC memory 10.

If the match/no-match signal that the decoder 30 receives from the redundancy switching information providing unit 11 indicates no match, the address of a current access operation does not include a defective memory cell, so that the decoder 30 sets all the switches 31-0 through 31-n in the normal switch position. If the match/no-match signal indicates a match, the decoder 30 sets one of the switches indicated by the data-position information received from the redundancy switching information providing unit 11 such that this switch is set in the redundancy switch position. With this arrangement, access is not performed with respect to the failed bit of the ECC memory 10 indicated by the data-position information, but is performed with respect to one of the redundant bits which serves as the redundancy destination.

In the description provided above, provision is made to use only one bit as a redundant bit. In the case in which an error correcting code allowing the correction of two or more bits is used, a plurality of failed bits may be replaced with a plurality of redundant bits serving as redundancy destinations. When the extended Hamming code is used, for example, such correction of multiple failed bits becomes possible.

In the configuration shown in Fig. 1, the redundancy controlling unit 12 is illustrated such as to act as an intermediary for the command signals and address signals between the host apparatus and the ECC memory 10, but may be configured such that these signals are allowed to pass without any change. Further, the ECC-on/off signal may be supplied to the ECC memory 10 as a register output responsive to the register content when data indicative of an ECC-on/off state is stored in the 1-bit register (not shown) according to a command signal(s) supplied from the exterior. The flow of command signals, address signals, and ECC-on/of signals are not directly related to the redundancy processing performed by the redundancy controlling unit 12, and an illustration thereof is omitted in Fig. 4.

When the configuration is such that the on/off state of the ECC function can be controlled from the exterior, the ECC function may be activated when reliability is given priority during the normal operation, for example. In this case, the switching of the switches 31-0 through 31-n is suspended such that the signal line of the data D[x] on the host apparatus side is always connected to the signal line of the data D[x] on the ECC memory side. If speed is given priority ahead of reliability, the ECC function is deactivated as previously described such that data recovery is performed based on the redundancy processing. In this manner, two different needs are answered by use of a single system.

Further, the selection of the on/off state of the ECC function may be fixedly set rather than configured to be controllable from the exterior. For example, a method of selecting the state by changing an interconnect layer (mask option), a method of selecting the state by changing a bonding connection at the time of package sealing, a method of selecting the state by use of a laser fuse, etc., may be utilized.

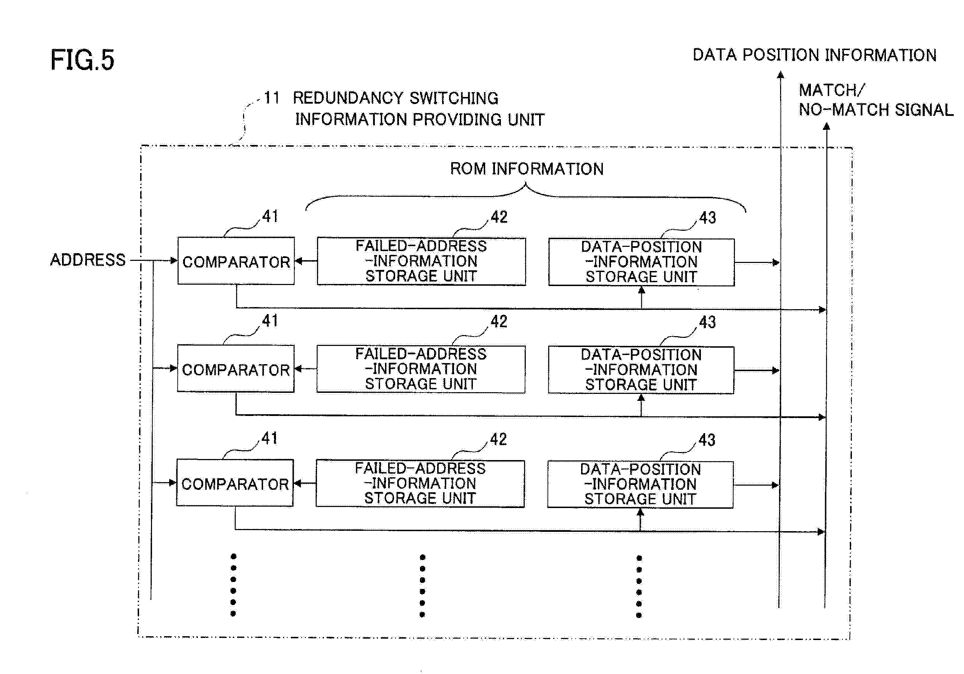

Fig. 5 is a drawing showing an example of the configuration of the redundancy switching information providing unit 11. The redundancy switching information providing unit 11 shown in Fig. 5 includes a plurality of comparators 41, a plurality of failed-address-information storage units 42, and a plurality of data-position-information storage units 43.

One comparator 41, one failed-address-information storage unit 42, and one data-position-information storage unit 43 are associated with each other as one set. Each of the comparators 41 compares the address supplied from the host apparatus with the address stored in the corresponding one of the failed-address-information storage units 42. A single failed-address-information storage unit 42 stores one failed address that is the address of a defective memory cell in the ECC memory 10. If there are m failed addresses, then, the m failed addresses are stored in m failed-address-information storage units 42, respectively.

When the result of comparison by one of the comparators 41 is a match, this comparator 41 outputs a match/no-match signal indicating a match. When the result of comparison by one of the comparators 41 is no match, this comparator 41 outputs a match/no-match signal indicating no match. The match/no-match signals output from the plurality of comparators 41 are consolidated into one match/no-match signal by a logic-sum gate (not shown) or the like, for example, for provision to the redundancy controlling unit 12. Namely, if at least one of the match/no-match signals indicates a match, a match/no-match signal indicative of a match is supplied to the redundancy controlling unit 12. If all of the match/no-match signals indicate no match, a match/no-match signal indicative of no match is supplied to the redundancy controlling unit 12.

A data-position-information storage unit 43 does not produce any output if the match/no-match signal output from the corresponding comparator 41 indicates no match. A data-position-information storage unit 43 outputs the stored data-position information if the match/no-match signal output from the corresponding comparator 41 indicates a match. The data-position information is supplied from the redundancy switching information providing unit 11 to the redundancy controlling unit 12.

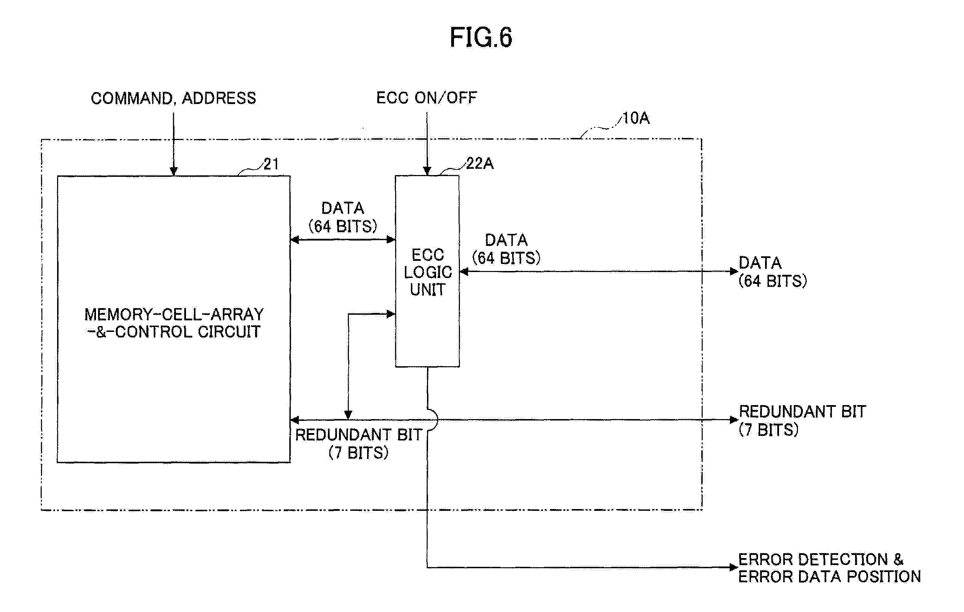

Fig. 6 is a drawing showing the configuration of a second embodiment of the ECC memory. In Fig. 6, the same elements as those of Fig. 2 are referred to by the same numerals, and a description thereof will be omitted.

In an ECC memory 10A shown in Fig. 6, an ECC logic unit 22A outputs an error detection signal indicative of the presence/absence of detected error and an error data position signal indicative of the bit position of an error bit contained in the read data. Other configurations are the same between the ECC memory 10 shown in Fig. 2 and the ECC memory 10A shown in Fig. 6.

In the ECC logic unit 22 of the ECC memory 10 shown in Fig. 2, as previously described, an error detection and error correction are performed with respect to read data if the ECC-on/off signal is set to the on state. An example will be examined here in which error-correction-purpose redundant bits are generated such that 71-bit data of the ECC memory 10 constitutes a Hamming code for which inter-code distance is three bits or more, for example. In this case, the presence/absence of error can be determined by checking whether the 71-bit data read from the ECC memory 10 has a bit pattern that is proper as a Hamming code. If error occurs in 1 bit, a difference between the 71-bit data and the Hamming code having the shortest Hamming distance from this 71-bit data is calculated, so that the 1 erroneous bit can be identified and corrected. Since the inter-code distance of the Hamming code is three, the presence of two-bit error allows only a determination to be made as to the presence/absence of error, but does not allow a determination to be made as to what Hamming code is a correct code. In practice, the syndrome information of the Hamming code may be calculated. The syndrome information uniquely indicates the presence/absence of error and the position of the error.

In the ECC memory 10A shown in Fig. 6, the ECC logic unit 22A is configured to output an error detection signal indicative of the presence/absence of error when the presence/absence of error is checked as described above, and is also configured to output an error data position signal indicative of the bit position of an error detected at the time of error correction. The ECC logic unit 22A may output the syndrome information of the Hamming code, for example. Except that provision is made to output these signals to the exterior, the ECC logic unit 22 and the ECC logic unit 22A may have the same configuration.

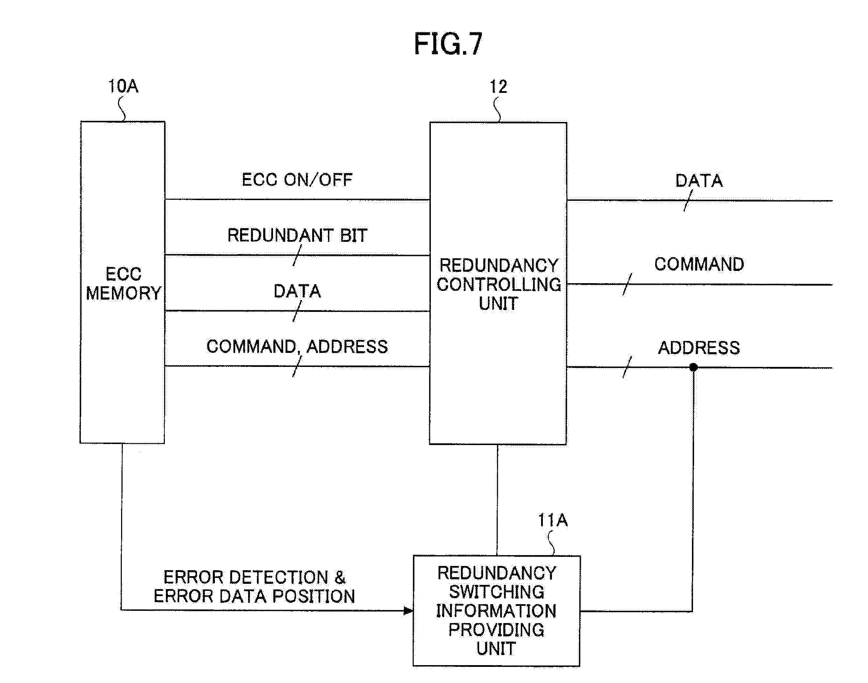

Fig. 7 is a block diagram showing the configuration of a redundancy-function-equipped semiconductor memory device when the ECC memory 10A of the second embodiment shown in Fig. 6 is used. In Fig. 7, the same elements as those of Fig. 1 are referred to by the same numerals, and a description thereof will be omitted.

The configuration shown in Fig. 7 differs from the configuration shown in Fig. 1 in that the ECC memory 10A supplies the error detection signal and error data position signal as described above. A redundancy switching information providing unit 11A sets data stored in the data-position-information storage units 43 in response to the supplied error detection signal and error data position signal.

To be specific, the ECC function of the ECC memory 10A is activated in the test mode for performing the testing of the ECC memory 10A. In the test mode, the write/read operation to write data to and read the data from the ECC memory 10A is performed with respect to each address while incrementing (or decrementing) the address one by one. When such read operation is performed with respect to each address, the redundancy switching information providing unit 11A receives from the host apparatus an address signal indicative of the address being accessed, and also receives the error detection signal and error data position signal from the ECC memory 10A.

In the redundancy switching information providing unit 11A, the address indicated by the supplied address signal is stored in a failed-address-information storage unit if the address detection signal indicates the presence of error, and the data-position information indicated by the supplied error data position signal is stored in a data-position-information storage unit. This is achieved in the configuration of the redundancy switching information providing unit shown in Fig. 5 by supplying the error detection signal as a latch instruction signal to a failed-address-information storage unit 42 and a data-position-information storage unit 43, with the address signal from the exterior and the error data position signal being supplied as input data to the failed-address-information storage unit 42 and the data-position-information storage unit 43, respectively.

In this case, the failed-address-information storage units 42 and the data-position-information storage units 43 may be implemented as a electrically writeable nonvolatile memory (EEPROM). With the use of the EEPROM, it is possible to automatically set and store information necessary for redundancy processing in the redundancy switching information providing unit 11A by simply performing the testing of the ECC memory with the ECC function being "on".

In the case in which the failed-address-information storage units 42 and the data-position-information storage units 43 are implemented such that data is stored as the cut or intact state of fuses, the error detection signal and the error data position signal may be supplied to an external tester apparatus or the like, rather than supplied to the redundancy switching information providing unit as shown in Fig. 7. In the exterior, the address being accessed, the error detection signal, and the error data position signal are monitored so as to identify the failed address and the failed data position. Then, a laser beam is used to cut the fuses in order to record the failed address and the failed data position.

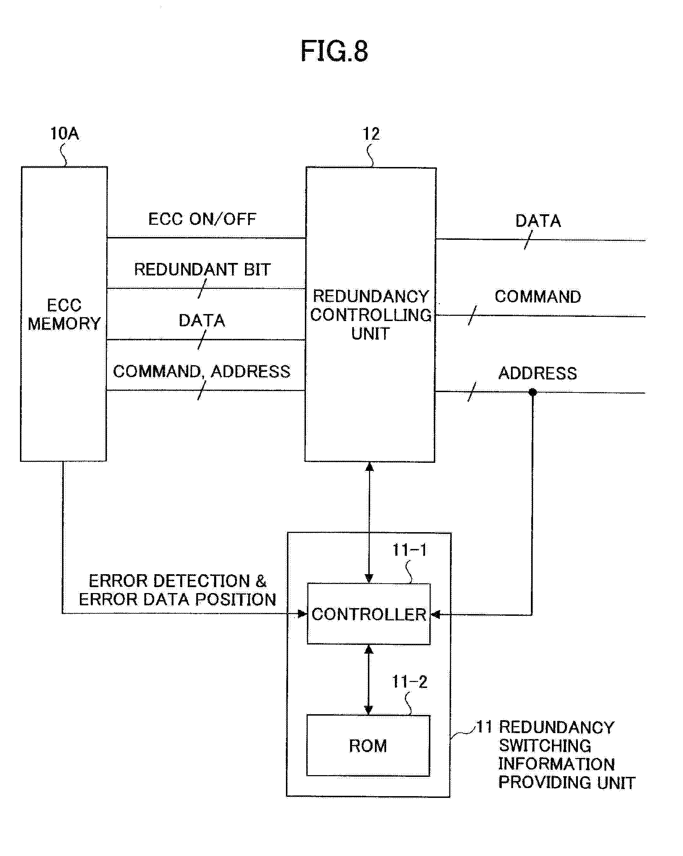

Fig. 8 is a block diagram showing a variation of the configuration of a redundancy-function-equipped semiconductor memory device when the ECC memory 10A of the second embodiment is used. In the configuration shown in Fig. 8, the redundancy switching information providing unit 11 includes a controller 11-1 and a ROM 11-2.

In this configuration, the storage unit for storing the failed address information and data position information as nonvolatile data is provided as a separate ROM 11-2. Such a separate ROM 11-2 may be implemented by use of a memory device that is available as a single separate unit such as a flash memory or FRAM (ferroelectric random access memory) macro. It suffices for the controller 11-1 to write the failed address and failed data position to the ROM 11-2 in response to the error detection signal supplied from the ECC memory 10A. Provision may be made such that the nonvolatile data written in this manner is loaded from the ROM 11-2 to the latches inside the controller 11-1 at the time of power-on of the semiconductor memory device, for example.

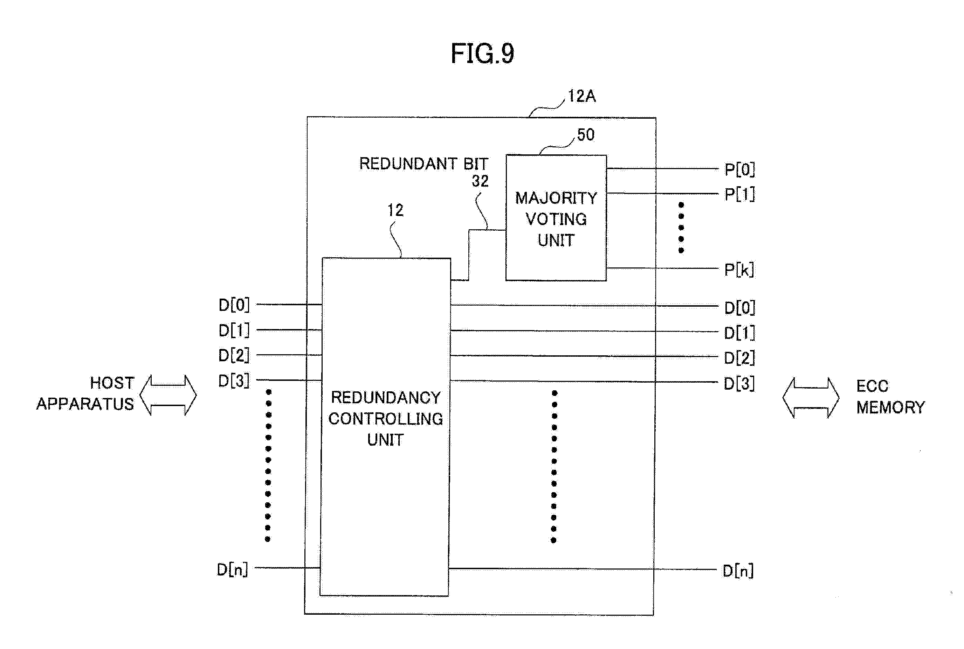

Fig. 9 is a drawing showing the configuration of a second embodiment of the redundancy controlling unit. In Fig. 9, the same elements as those of Fig. 4 are referred to by the same numerals, and a description thereof will be omitted.

A redundancy controlling unit 12A shown in Fig. 9 includes a majority voting unit 50 in addition to the redundancy controlling unit 12 shown in Fig. 4. The majority voting unit 50 is connected to the redundant-bit signal line 32 (see Fig. 4) of the redundancy controlling unit 12, and is also connected to the signal lines of redundant bits P[0] through P[k] that are input/output with respect to the ECC memory 10.

If the ECC memory 10 of Fig. 2 is used, for example, the redundant bits P[0] through P[k] are 7 bits (i.e., k=6). The redundancy controlling unit 12 of Fig. 4 simply replaces one failed bit with one redundant bit, so that if there are 7 redundant bits, for example, 6 bits are wasted.

In the present embodiment, the majority voting unit 50 is provided so that the majority voting logic improves the reliability of the redundancy bit replacement. When supplying data (one bit corresponding to the failed bit position of write data) from the redundancy controlling unit 12A to the ECC memory 10, the majority voting unit 50 passes the data of the redundant-bit signal line 32 to all the output bits P[0] through P[k] without any change. As a result, the one bit at the failed bit position of the write data is stored in each of the k+1 memory cells corresponding to the redundant bits P[0] through P[k]. When reading the bit replaced by a redundant bit is read from the ECC memory 10, the majority voting unit 50 performs majority voting with respect to the k+1 bits read from the k+1 memory cells corresponding to the redundant bits P[0] through P[k], and transmits to the redundant-bit signal line 32 a logic value that is one of "0" and "1" found in greater numbers in the k+1 bits.

With this configuration, it is possible to significantly improve the reliability of a bit replaced by a redundant bit. Under normal conditions, the testing of redundant cells (i.e., the k+1 bits as replacements) needs to be conducted in the same manner as the testing of normal cells, thereby checking whether these redundant cells properly function as spares. If the majority voting method is employed for the redundancy replacement bits as described above, however, the data of the bit to be replaced by redundancy can be made far more reliable than data of normal memory cells. As a result, testing is no longer necessary for the k+1 memory cells that function as replacements. Even if the k+1 bits serving as replacements include one or more defective cells as a result of testing, or end up containing one or more defective cells over time as a result of secular changes, proper redundancy processing can be achieved as long as the number of the defective cells is no larger than 3 in the case of 7-bit majority voting, for example.

If the ECC that is capable of correcting one-bit error is employed, for example, any error correcting codes of the ECC memory are known to contain only one error bit at the maximum as long as a proper operation is confirmed as a result of testing with the ECC function being "on". Redundancy processing is necessary only when there is error in the data portion (i.e., not in the redundancy-bit portion). If an error that is only one bit at the maximum is present in the data portion, this necessarily follows that no error is present in the redundant-bit portion.

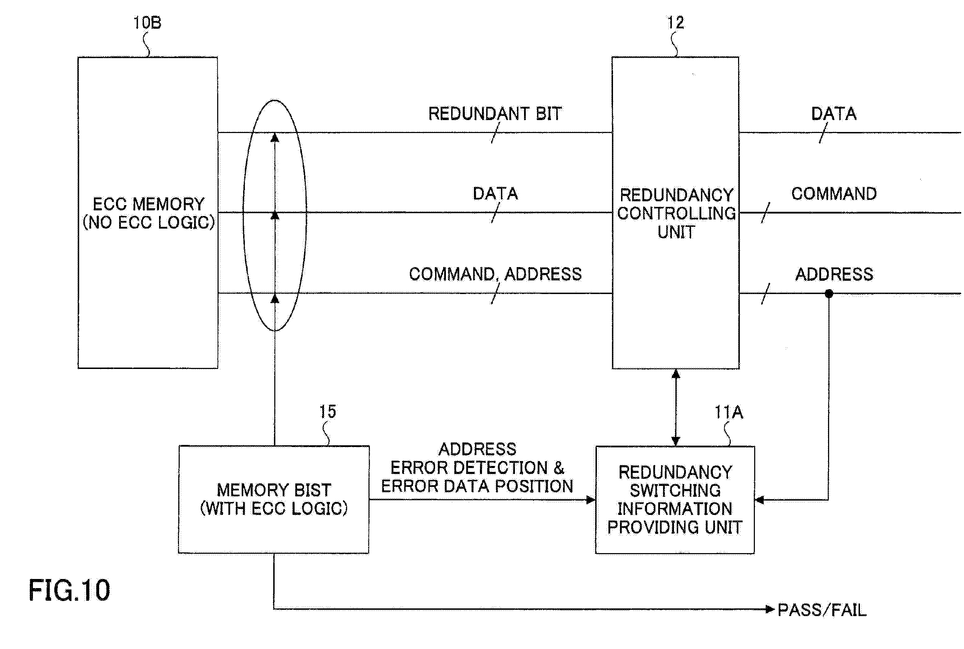

Fig. 10 is a block diagram showing a variation of the configuration of the redundancy-function-equipped semiconductor memory device according to the present invention. The semiconductor memory device of Fig. 10 includes a memory 10B, the redundancy switching information providing unit 11A, the redundancy controlling unit 12, and a memory BIST 15. The redundancy switching information providing unit 11A is the same as the redundancy switching information providing unit described with reference to Fig. 7. The memory BIST (Built-in Self Test) 15 is a module that serves to perform automatic testing of a memory inside a system such as a SOC. The memory 10B is what is left after removing the ECC logic unit 22 from the ECC memory 10.

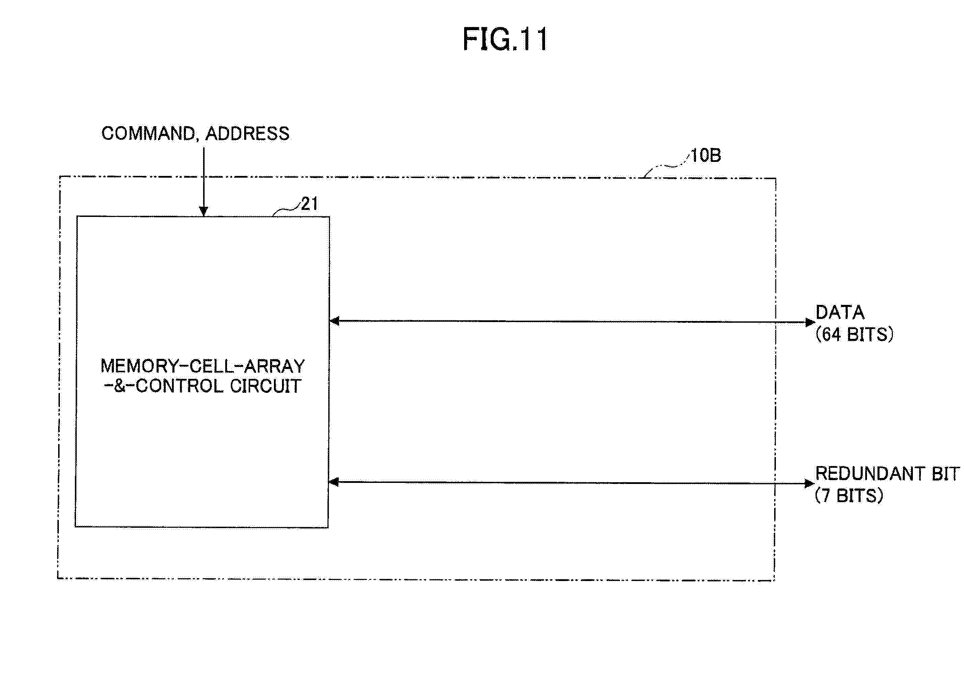

Fig. 11 is a drawing showing the configuration of the memory 10B shown in Fig. 10. In Fig. 11, the same elements as those of Fig. 2 are referred to by the same numerals, and a description thereof will be omitted. As shown in Fig. 11, the memory 10B has a configuration in which the data inputs/outputs and redundant bit inputs/outputs of the memory-cell-array-&-control circuit 21 are directly connected to the exterior after removing the ECC logic unit 22 from the ECC memory 10 shown in Fig. 2. Namely, the memory 10B is configured to store data bits equal in number to the number of redundant bits in addition to the normal data bit width that is 2 to the power of a positive integer.

Turning back to Fig. 10, the memory BIST 15 includes an ECC logic unit. At the time of test operation, the memory BIST 15 automatically generates error-correction-purpose redundant bits, and writes the generated bits together with the test data to the memory 10B. The written code (data + redundant bits) are subsequently read, and a syndrome (correction information) is generated from the read code. If error is detected (and the error is not in the redundant bits), the syndrome information is written to the nonvolatile memory of the redundancy switching information providing unit 11A. Further, the read code is corrected for error, and the data of the corrected code is compared with the expected value (correct data that has been written). If the comparison indicates a match for all the addresses, a Pass signal is output as a test result. If no match is found with respect to any one or more of the addresses, Fail is output as a test result. A semiconductor memory device that has output Fail is discarded as being defective.

In this manner, the semiconductor memory device of Fig. 10 has the memory 10B without the ECC function and the memory BIST 15 with the ECC function. Especially when a plurality of memories are provided, the ECC function may be centrally provided in the memory BIST rather than provided separately in each of the memories, thereby achieving an efficient circuit configuration.

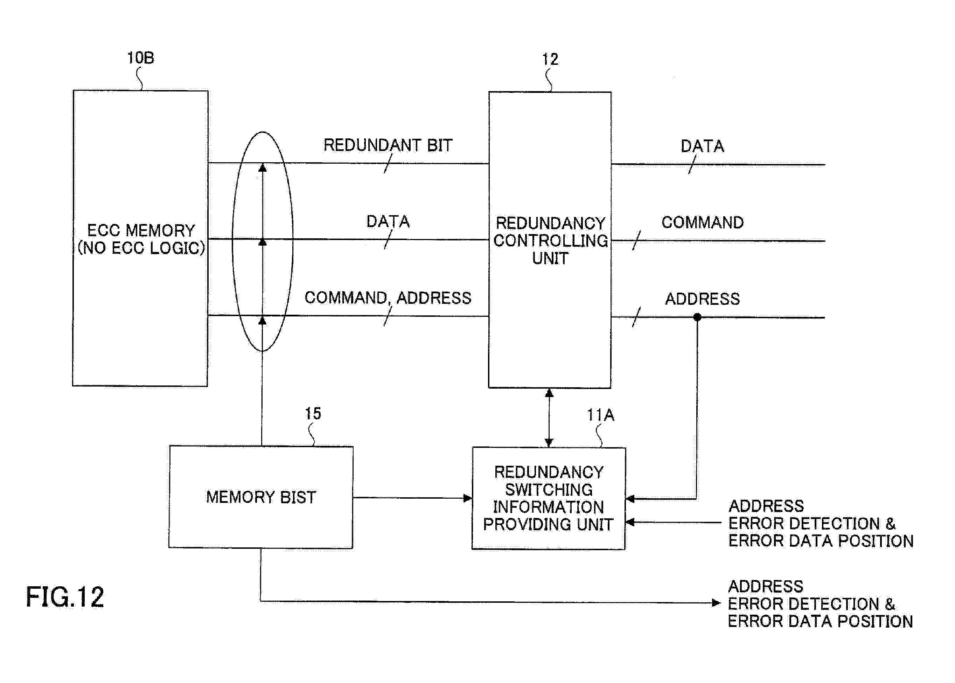

Fig. 12 is a block diagram showing another variation of the configuration of the redundancy-function-equipped semiconductor memory device according to the present invention. In Fig. 12, the same elements as those of Fig. 10 are referred to by the same numerals, and a description thereof will be omitted.

The semiconductor memory device of Fig. 12 includes a memory 10B, the redundancy switching information providing unit 11A, the redundancy controlling unit 12, and a memory BIST 15A. The redundancy switching information providing unit 11A is the same as the redundancy switching information providing unit described with reference to Fig. 7. The memory BIST 15A is a module that serves to perform automatic testing of a memory inside a system such as an SOC, and is not provided with the ECC function unlike the memory BIST 15 shown in Fig. 10. The memory 10B is what is left after removing the ECC logic unit 22 from the ECC memory 10.

At the time of test operation, the memory BIST 15A automatically generates test data, and writes the generated test data to the memory 10B. Thereafter, the memory BIST 15A reads the written data, and compares the read data with the expected value (the correct data that has been written). Based on this comparison, the memory BIST 15A checks whether the tested address includes error, and finds the position of the error if there is error.

The memory BIST 15A outputs an address signal indicative of the address, an error detection signal indicating whether there is an error, and an error data position signal indicative of the position of an error bit in the data. These signals are detected by a tester apparatus or the like situated outside the semiconductor memory device. In the exterior, the address being output, the error detection signal, and the error data position signal are monitored so as to identify the failed address and the failed data position. Then, setting signals may be provided from the exterior to the redundancy switching information providing unit 11A in order to record the failed address and the failed data position. If the redundancy switching information providing unit 11 is configured such that nonvolatile data is stored by use of fuses, a layer beam may be used to cut the fuses in order to record the failed address and the failed data position.

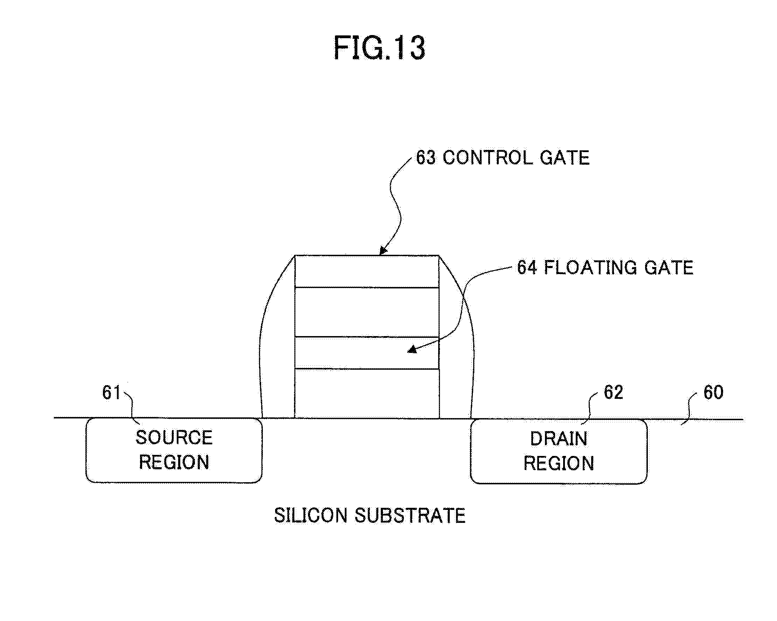

Fig. 13 is a drawing showing an example of a nonvolatile information storage unit provided in the redundancy switching information providing unit 11. In the example shown in Fig. 13, a source region 61 and drain region 62 are created in the diffusion layer of a silicon substrate 60, and a floating gate 64 and control gate 63 are formed on the silicon substrate 60 between the source region 61 and the drain region 62, thereby providing a nonvolatile information storage unit for the storage of one bit. In this configuration, an electric current running between the source region 61 and the drain region 62 in response to a voltage applied to the control gate 63 varies depending on the presence/absence of electric charge trapped in the floating gate 64. Such presence/absence of electric charge represents "1"/"0" of data. When data is to be written, according to one method, an electric current is made to flow between the source region 61 and the drain region 62 to generate hot carriers, which are utilized to inject electric charge into the floating gate 64.

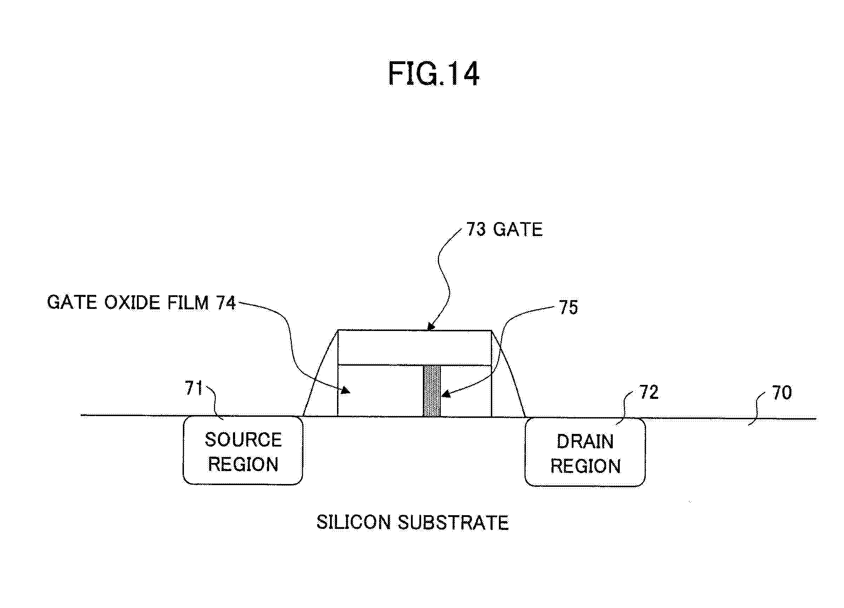

Fig. 14 is a drawing showing another example of a nonvolatile information storage unit provided in the redundancy switching information providing unit 11. In the example shown in Fig. 14, a source region 71 and drain region 72 are created in the diffusion layer of a silicon substrate 70, and a gate oxide film 74 and gate 73 are formed on the silicon substrate 70 between the source region 71 and the drain region 72, thereby providing a nonvolatile information storage unit for the storage of one bit. The presence/absence of a dielectric breakdown 75 in the gate oxide film (or inter-layer film) 74 serves to record data. When data is to be written, a voltage that destroys the gate oxide film 74 is supplied to the gate 73.

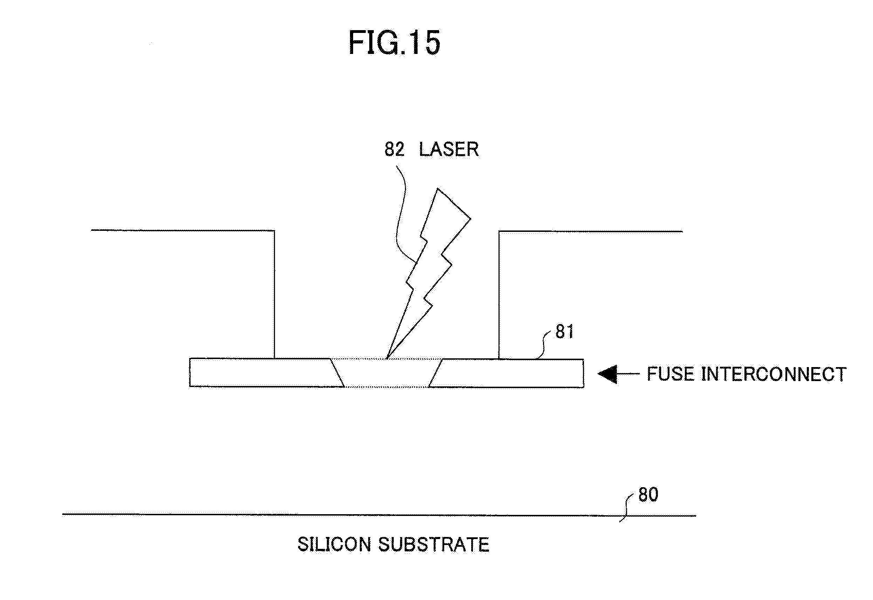

Fig. 15 is a drawing showing another example of a nonvolatile information storage unit provided in the redundancy switching information providing unit 11. In the example shown in Fig. 15, a fuse interconnect 81 is formed in an interconnect layer provided on a silicon substrate 80, thereby providing a nonvolatile information storage unit for the storage of one bit. When data is to be written, a laser beam 82 may be used to cut the fuse interconnect 81. Data reading is achieved by checking whether an electric current flows through the fuse interconnect 81. An alternative method would be to melt and cut the fuse interconnect 81 by causing an excessive electric current to flow through the fuse interconnect 81, rather than cutting it by use of a laser beam.

In the following, embodiments relating to the chip configuration of the semiconductor memory device of the present invention will be described. The semiconductor memory device of the present invention maybe configured such that a single chip serving as an SOC includes the ECC memory 10, the redundancy switching information providing unit 11, and the redundancy controlling unit 12. Alternatively, the semiconductor memory device of the present invention may be implemented by use of a plurality of separate chips.

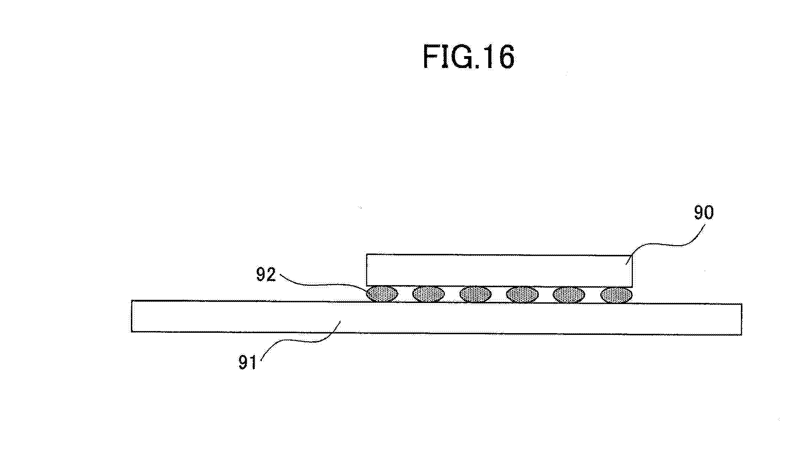

Fig. 16 is a drawing showing an example of the chip configuration of the semiconductor memory device according to the present invention. In the configuration shown in Fig. 16, a chip 90 is mounted face-down on a chip 91, and these chips are electrically connected to each other through connection bumps 92. The chip 90 may include the ECC memory 10, and the chip 91 may include the redundancy switching information providing unit 11 and the redundancy controlling unit 12. In this manner, the ECC memory 10 and the other parts may be formed on separate chips (i.e., on separate semiconductor substrates).

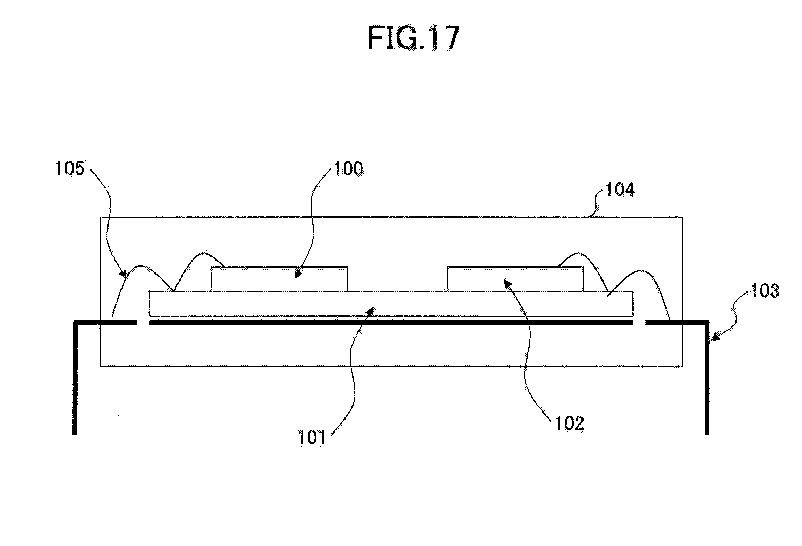

Fig. 17 is a drawing showing another example of the chip configuration of the semiconductor memory device according to the present invention. In the configuration shown in Fig. 17, chips 100 and 102 are mounted on a chip 101 with their circuit-implemented faces directed in the same direction (facing upward in this example), and bonding wires 105 electrically connect between the chips. The chips 100 through 102 are sealed inside a package 104, and are electrically connected to the exterior of the package 104 through lead frames 103. The chip 100 may include the ECC memory 10, and the chip 101 may include the redundancy controlling unit 12 and the controller 11-1, with the chip 102 including the ROM 11-2 (see Fig. 8). In this manner, the ECC memory 10 and the ROM portion may be implemented as respective separate chips, and the other parts may be implemented as another separate chip.

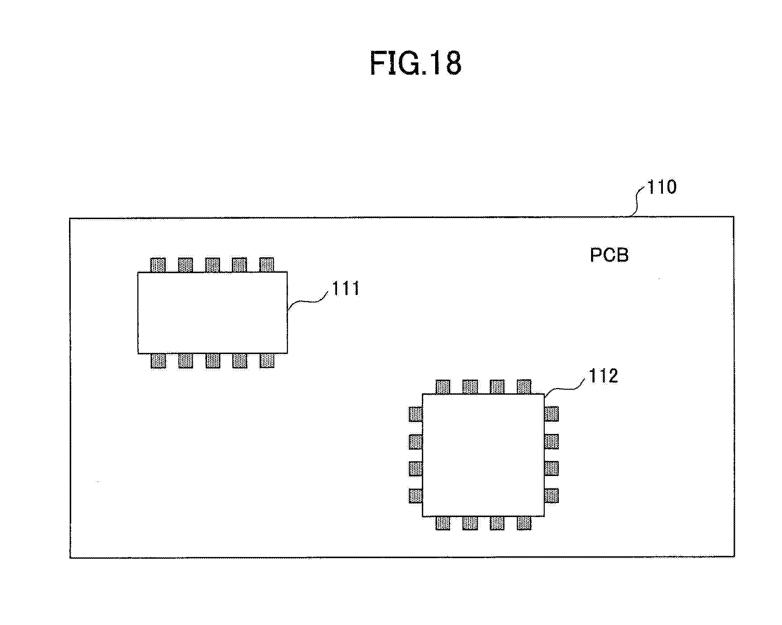

Fig. 18 is a drawing showing yet another example of the chip configuration of the semiconductor memory device according to the present invention. In the configuration shown in Fig. 18, packaged chips 111 and 112 are mounted on a printed circuit board 110, and are electrically connected to each other through interconnect lines on the printed circuit board 110. In this example, the packaged chip 111 may include the ROM 11-2, and the packaged chip 112 may include the other parts.

Further, the present invention is not limited to these embodiments, but various variations and modifications may be made without departing from the scope of the present invention.

## Claims

1. A semiconductor memory device, **characterized by** comprising:
a memory configured to input/output first data and second data in parallel, the first data being all or part of data comprised of a predetermined number of bits that is 2 to the power of a positive integer, and the second data being comprised of a number of bits necessary to correct error of the data comprised of the predetermined number of bits;
a redundancy switching information providing unit configured to supply redundancy switching information in response to an address signal supplied to the memory; and
a redundancy controlling unit situated between the memory and input/output nodes equal in number to a number of bits of the first data, having a first path that couples a given bit of the input/output nodes to a corresponding bit of the first data of the memory and a second path that couples the given bit of the input/output nodes to a predetermined bit of the second data of the memory, and configured to select and enable one of the first path and the second path in response to the redundancy switching information.

2. The semiconductor memory device as claimed in claim 1, wherein the memory includes an ECC logic unit configured to correct error of the first data based on the first data and the second data and further configured to allow an error correction function thereof to be set to an "off" state.

3. The semiconductor memory device as claimed in claim 1, wherein the given bit of the input/output nodes is selected by the redundancy switching information.

4. The semiconductor memory device as claimed in claim 1, wherein the redundancy switching information providing unit is configured to supply, as the redundancy switching information, information indicative of whether there is a failed bit at an address indicated by the address signal and information indicative of a position of the failed bit.

5. The semiconductor memory device as claimed in claim 1, wherein the redundancy controlling unit is configured to write the given bit of the input/output nodes to each of a plurality of bits of the second data of the memory if the second path is selected for a write operation with respect to the memory, and is configured to supply to the given bit of the input/output nodes a value determined through majority voting among the plurality of bits of the second data of the memory if the second path is selected for a read operation with respect to the memory.

6. The semiconductor memory device as claimed in claim 1, wherein the redundancy switching information providing unit includes:
a failed-address-information storage unit to store a failed address of the memory;
a data-position-information storage unit to store a position of a failed bit at the failed address; and
a comparator unit configured to compare an address indicated by the address signal with the failed address stored in the failed-address-information storage unit.

7. The semiconductor memory device as claimed in claim 6, wherein the memory includes an ECC logic unit configured to output error information indicative of presence/absence of error in the first data and indicative of a bit position of the error, and wherein the redundancy switching information providing unit is coupled to the ECC logic unit, and is configured to store the failed address and the failed bit position in the failed-address-information storage unit and the data-position-information storage unit, respectively, in response to the error information.

8. The semiconductor memory device as claimed in claim 1, further comprising a memory BIST configured to perform automatic testing of the memory, wherein the memory BIST includes an ECC logic unit configured to correct error of the first data based on the first data and the second data.

9. The semiconductor memory device as claimed in claim 2, wherein the ECC logic unit is configured to allow the error correction function to be set to "on" or "off" in response to a signal supplied from an exterior.

10. The semiconductor memory device as claimed in claim 2, wherein the ECC logic unit is configured such that the error correction function thereof is fixedly set to the "off" state.

11. The semiconductor memory device as claimed in claim 1, wherein the redundancy switching information providing unit includes an electrically readable and writable ROM that stores a failed address of the memory and a position of a failed bit at the failed address.

12. The semiconductor memory device as claimed in claim 11, wherein the ROM includes a memory cell having a floating gate structure.

13. The semiconductor memory device as claimed in claim 11, wherein the ROM includes a memory cell utilizing a breakdown/intact state of a gate oxide film of a MOS transistor.

14. The semiconductor memory device as claimed in claim 11, wherein the ROM includes a fuse that melts to be cut in response to an excessive electric current.

15. The semiconductor memory device as claimed in claim 1, wherein the redundancy switching information providing unit includes a fuse that is cut or left intact to store a failed address of the memory and a position of a failed bit at the failed address.

16. The semiconductor memory device as claimed in claim 1, comprising:
a first semiconductor chip inclusive of the memory; and
a second semiconductor chip inclusive of the redundancy controlling unit.

17. The semiconductor memory device as claimed in claim 16, wherein the second semiconductor chip further includes the redundancy switching information providing unit.

18. The semiconductor memory device as claimed in claim 16, comprising a third semiconductor chip inclusive of the redundancy switching information providing unit.

19. The semiconductor memory device as claimed in claim 16, wherein one of the first semiconductor chip and the second semiconductor chip is mounted face-down on another one of the first semiconductor chip and the second semiconductor chip.

20. The semiconductor memory device as claimed in claim 16, wherein one of the first semiconductor chip and the second semiconductor chip is mounted on another one of the first semiconductor chip and the second semiconductor chip such that circuit-implemented faces thereof do not face each other.

21. The semiconductor memory device as claimed in claim 16, wherein the first semiconductor chip and the second semiconductor chip are mounted on a printed circuit board.

22. The semiconductor memory device as claimed in claim 2, wherein the error correction function is based on the Hamming code.

23. The semiconductor memory device as claimed in claim 2, wherein the error correction function is based on the extended Hamming code.

24. The semiconductor memory device as claimed in claim 2, wherein the error correction function is based on the horizontal and vertical parity code.

25. The semiconductor memory device as claimed in claim 2, wherein the "off" state of the error correction function is fixedly made by use of a mask option.

26. The semiconductor memory device as claimed in claim 2, wherein the "off" state of the error correction function is fixedly made by use of bonding.

27. The semiconductor memory device as claimed in claim 2, wherein the "off" state of the error correction function is fixedly made by use of a laser fuse.
